# EUROPEAN PATENT APPLICATION

(11) **EP 4 394 418 A1**
(43) Date of publication of application: **03.07.2024**
(21) Application number: 22217445.0
(22) Date of filing: 31.12.2022
(51) Int. Cl.: G01R 33/00, G01R 33/06, G01R 33/07

(54) **SEMICONDUCTOR DEVICE WITH INTEGRATED SOFT-MAGNETIC COMPONENT, AND METHOD OF PRODUCING SAME**

(71) Applicant: Melexis Technologies SA, 2022 Bevaix (CH)
(72) Inventor: DUPONT, Guido, 2022 Bevaix (CH); ROSENFELD, Daniel, 2022 Bevaix (CH); TOMBEZ, Lionel, 2022 Bevaix (CH); VAN DER WIEL, Appo, 3980 Tessenderlo (BE); CLOSE, Gael, 2022 Bevais (CH)
(74) Representative: Jacobs, Lambert

(57) **Abstract**

A semiconductor device comprising a semiconductor substrate, the substrate comprising an excitation circuit for applying an excitation signal, and a soft-magnetic component for guiding magnetic flux lines; the soft-magnetic component being electrically connected to said excitation by means of at least two electrical contacts in the form of back contacts or side contacts; the substrate further comprising at least one electromagnetic transducer operatively connected to the soft-magnetic component; the excitation circuit comprises a modulator for providing a modulated signal to the soft-magnetic component to modulate its magnetic permeability; the substrate further comprising a demodulator configured to demodulate signals obtained from the at least one electromagnetic transducer.

## Description

### Field of the invention

The present invention relates in general to the field of semiconductor devices comprising a semiconductor substrate comprising a soft-magnetic component. The present invention is also related to a method of producing such a semiconductor device.

### Background of the invention

Various kinds of semiconductor devices comprising an active soft-magnetic component or a passive soft-magnetic component, are known in the art. Examples of devices with an active soft-magnetic component are devices with a magneto-resistive (MR) component, or with a magneto-impedance (MI) component. Examples of devices with a passive soft-magnetic component are integrated fluxgates, integrated transformers, magnetic sensor devices with Hall elements and an flux concentrator (IMC), etc.

There is always room for improvements or alternatives.

### Summary of the invention

It is an object of embodiments of the present invention to provide a semiconductor device comprising a semiconductor substrate comprising a soft-magnetic component, and a method for producing that semiconductor device.

It is an object of embodiments of the present invention to provide a semiconductor device wherein the soft-magnetic component is used in a non-classical manner, e.g. for additional functionality, and/or for safety purposes.

It is an object of embodiments of the present invention to provide a semiconductor device having at least two modes of operation: a first mode in which the soft-magnetic component is used in its normal way (as is known in the art), and a second mode, wherein the soft-magnetic component is used in a non-standard manner, for the purpose of additional functionality, and/or for safety purposes.

These and other objectives are accomplished by embodiments of the present invention.

According to a first aspect, the present invention provides a semiconductor device, comprising: a semiconductor substrate (e.g. CMOS substrate) comprising: an excitation circuit for applying an excitation signal (e.g. a current or a voltage signal), and a soft-magnetic component (e.g. comprising or made of an FeNi alloy) for guiding magnetic flux lines (e.g. of a magnetic field to be measured); wherein the soft-magnetic component is electrically connected to said excitation circuit by means of at least two electrical contacts (e.g. E1, S1); wherein the at least two electrical contacts are back contacts situated at a bottom surface of the soft-magnetic component side contacts situated at a lateral surface of the soft magnetic component; wherein the semiconductor substrate further comprises at least one electromagnetic transducer (e.g. at least one Hall element, at least one coil) arranged in close vicinity of the soft-magnetic component, and operatively connected thereto; wherein the excitation circuit comprises a modulator for providing a modulated signal (e.g. a PWM signal, a PSK (phase shift keying) signal, an FM modulated signal, an AM modulated signal) to the soft-magnetic component in order to modulate its magnetic permeability; wherein the semiconductor device further comprises a demodulator configured to demodulate signals obtained from the at least one electromagnetic transducer.

In this embodiment, the soft-magnetic component is preferably a passive component during normal operation of the semiconductor device, e.g. as a sensor device, an integrated transformer, or an integrated fluxgate.

In this embodiment, the soft-magnetic component may e.g. be an integrated magnetic flux concentrator (IMC) or an integrated fluxgate, or the core of a transformer, which typically "left floating" during normal operation, or which is connected to a single potential (e.g. ground).

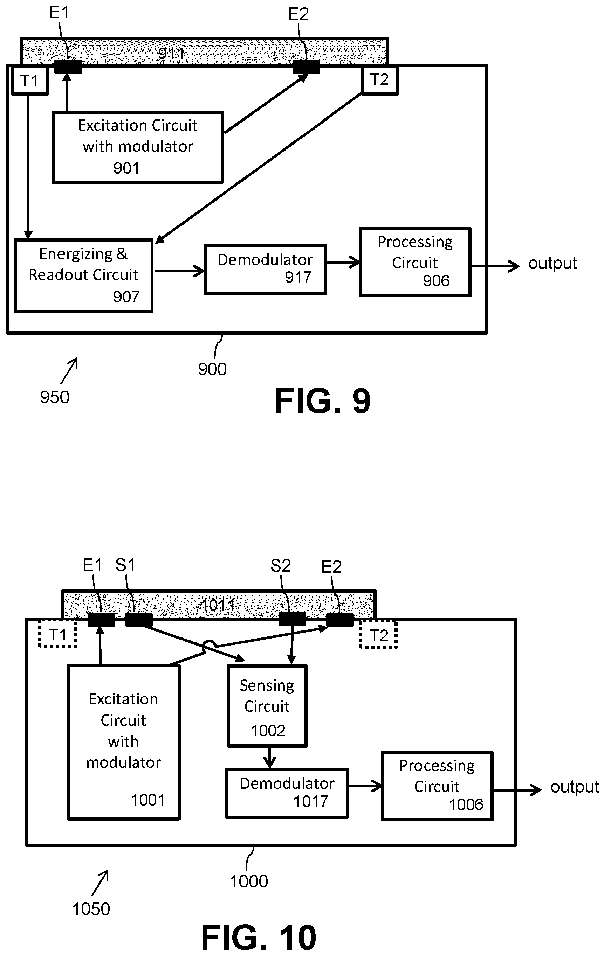

An example of this embodiment is illustrated in FIG. 9.

According to a second aspect, or a further embodiment of the first aspect, the present invention provides a semiconductor device, comprising: a semiconductor substrate (e.g. CMOS substrate) comprising: an excitation circuit for applying an excitation signal (e.g. a current or a voltage signal), and a sensing circuit for measuring a response signal (e.g. a voltage or a current signal), and a soft-magnetic component (e.g. comprising or made of an FeNi alloy) for guiding magnetic flux lines (e.g. of a magnetic field to be measured); wherein the soft-magnetic component is electrically connected to said excitation circuit and to said sensing circuit by means of at least two electrical contacts (e.g. E1, E2, 51, S2); and wherein the at least two electrical contacts are back contacts situated at a bottom surface of the soft-magnetic component side contacts situated at a lateral surface of the soft magnetic component; wherein the excitation circuit comprises a modulator for providing a modulated signal (e.g. a PWM signal, a PSK (phase shift keying) signal, an FM modulated signal, an AM modulated signal) to the soft-magnetic component in order to modulate its magnetic permeability; wherein the semiconductor device further comprises a demodulator configured to demodulate signals obtained from the sensing circuit.

In this embodiment, the soft-magnetic component is preferably an active component during normal operation of the semiconductor device, e.g. as an MR sensor or as an MI sensor device.

An example of this embodiment is illustrated in FIG. 10.

According to a third aspect, or a further embodiment of the first aspect, the present invention provides a semiconductor device, comprising: a semiconductor substrate (e.g. CMOS substrate) comprising: an excitation circuit for generating an excitation signal (e.g. a current or a voltage signal), and a sensing circuit for measuring or detecting a response signal (e.g. a voltage or a current signal), and a soft-magnetic component (e.g. comprising or made of an FeNi alloy) for guiding magnetic flux lines (e.g. of a magnetic field to be measured); wherein the soft-magnetic component is electrically connected to said excitation circuit and to said sensing circuit by means of at least two electrical contacts (e.g. E1, 51); wherein the at least two electrical contacts are back contacts situated at a bottom surface of the soft-magnetic component or side contacts situated at a lateral surface of the soft magnetic component; wherein the semiconductor device (e.g. the sensing circuit, or a processor circuit connected to the sensing circuit) is configured to detect a defect (e.g. a mechanical or electrical defect) based on the response signal.

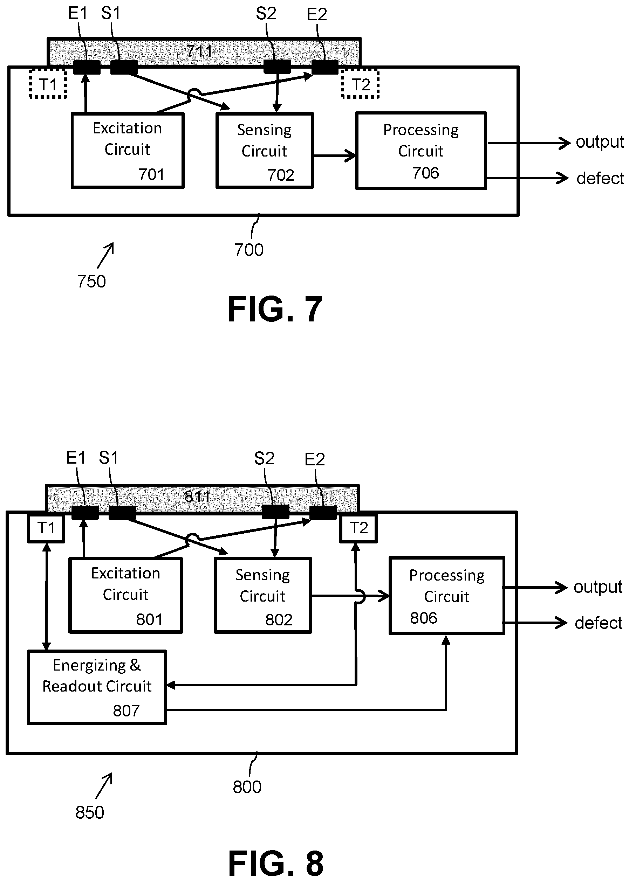

Examples of this embodiment are illustrated in FIG. 7 and FIG. 8.

In this embodiment, the soft-magnetic component may be an active component during normal operation of the semiconductor device, or a passive component.

In an embodiment of the third aspect, the semiconductor substrate further comprises at least one electromagnetic transducer (e.g. H1, H2) (e.g. at least one Hall element, at least one coil) arranged in close vicinity of the soft-magnetic component; and the semiconductor substrate further comprises an energizing and readout circuit connected to said at least one electromagnetic transducer; and the semiconductor device has a first mode of operation, wherein the excitation circuit and sensing circuit are actively used to detect a defect; and the semiconductor device has a second mode of operation, wherein the excitation circuit is deactivated, and the energizing and readout circuit are used to obtain a signal from the electromagnetic transducers.

In this embodiment, the soft-magnetic component is preferably a passive component during normal operation of the semiconductor device, e.g. as a sensor device, as a transformer, as an integrated fluxgate. An example of such embodiment is illustrated in FIG. 8.

In one embodiment, the soft-magnetic component may act as an IMC, and the transducers are one or more Hall plates, and the "energizing and readout circuit" comprises a "biasing and readout" circuit for Hall plates.

In another embodiment, the soft-magnetic component may act as an integrated fluxgate, and the transducers are two or more coils, at least one excitation coil and at least one pick-up coil, and the "energizing and readout" circuit comprises a " transmitter circuit, and a receiver circuit" for coils.

In embodiments of the present invention, the at least one electromagnetic transducer is at least one Hall element;

In embodiments of the present invention, the at least one electromagnetic transducer is at least one coil.

In embodiments of the present invention, the semiconductor device may be a sensor device.

In embodiments of the present invention, the excitation circuit is configured for applying a voltage (e.g. a dc voltage, an ac voltage, a combination of a dc voltage and an ac voltage) over said at least two electrical contacts and the sensing circuit is configured for measuring a current flowing through the soft-magnetic component.

In embodiments of the present invention, the excitation circuit is configured for flowing a current (e.g. a dc current, an ac current, or a combination of a dc current and an ac current) through the soft-magnetic component, and the sensing circuit is configured for measuring a voltage over the contacts.

In embodiments of the present invention, the processing circuit may comprise a programmable processor. The processing circuit may be configured for detecting an open circuit between said at least two contacts, e.g. by detecting that substantially no current is flowing through the soft-magnetic component, or that an electrical resistance R is larger than a predefined value, or that the magnitude of an electrical impedance |Z| is larger than a predefined value. The processing circuit may be further configured to provide an output signal indicative of a detection of said defect.

In embodiments of the present invention, the semiconductor device may for example be a magnetic sensor device, e.g. a position sensor device, an angular sensor device, a linear sensor device, a proximity sensor device, an integrated fluxgate, an integrated transformer.

In embodiments of the present invention, the semiconductor device may have two modes of operation, including a first mode (e.g. " normal operation mode") in which the device performs its normal function, e.g. measuring a magnetic field value, determining a position, converting an input voltage & current into an output voltage & current, etc.; and a second mode wherein a diagnostic test is performed to verify the electrical and/or mechanical integrity of the device. Such a device is better suited in applications where "functional safety" is important. During the "normal mode of operation", the soft-magnetic material may be left electrically floating (e.g. in case of an integrated fluxgate, or a transformer, or an IMC), or may be provided with a dc signal (e.g. in case of an MR sensor), or may be provided with an ac signal (e.g. in case of an MI sensor).

In embodiments of the present invention, the semiconductor device may have two modes of operation, including a first mode (e.g. " normal operation mode") in which the device performs its normal function, e.g. measuring a magnetic field value, determining a position, converting an input voltage & current into an output voltage & current, etc., and the "diagnostic test" may be one or more additional steps performed during normal operation of the device.

In embodiments of the present invention, the excitation circuit may be configured for generating an alternating voltage or an alternating current

In embodiments of the present invention, the magnetic component may be arranged on top of the semiconductor substrate, or may be partially or fully embedded in the semiconductor substrate. The magnetic component is preferably a "thin film" component.

In embodiments of the present invention, the semiconductor substrate comprises a polyimide layer, and the magnetic component is provided on top of the polyimide layer.

In embodiments of the present invention, the magnetic component is provided on top of, and in electrical contact with an electrically conductive seed layer. Preferably the magnetic component is provided at least partially using electroplating.

In embodiments according to the first aspect, the semiconductor device may optionally further comprise a modulator and a demodulator (e.g. as specified in embodiments according to the second or third aspect), and/or at least one electromagnetic transformer (e.g. as specified in embodiments according to the third aspect).

In embodiments according to the second aspect, the semiconductor device may optionally further comprise one or more electromagnetic transducers (e.g. one or more Hall elements or coils), and if these transducers are read-out while a modulated signal is applied to the soft-magnetic component, then the signals obtained from these transducers need to be demodulated.

In embodiments according to the third aspect, the semiconductor device may optionally be further configured for performing a "diagnostic test" as described in embodiments according to the first aspect, e.g. by testing if the soft-magnetic component provides a closed circuit or an open circuit between the at least two contacts.

In embodiments of the present invention, the semiconductor device may be further configured for performing a resistance measurement, or an impedance measurement. The latter involves determining an attenuation and a phase shift between the excitation signal and the sensed signal, e.g. between the applied voltage and the sensed current, or between the applied current and the sensed voltage. The impedance value can be expressed by a complex value having a reel part and a non-zero imaginary part.

In embodiments of the present invention, the semiconductor device is an integrated circuit (so called "chip") encapsulated in a moulded package.

In preferred embodiments of the present invention, the semiconductor substrate is overmoulded in a way such that the soft-magnetic element is not exposed (after moulding), and is not directly accessible from the outside of the moulded package.

In embodiments of the present invention, the soft-magnetic material is a ferromagnetic material, e.g. FeNi or an Fe-Ni alloy.

In preferred embodiments of the present invention, the semiconductor substrate mainly comprises silicon.

In preferred embodiments of the present invention, the semiconductor substrate (not considering the soft-magnetic element), is a "CMOS device", i.e. is produced using a CMOS compatible process.

In embodiments of the present invention, the processing circuit may be, or may comprise a programmable digital processor.

In embodiments of the present invention, the semiconductor substrate further comprises a non-volatile memory, operatively connected to the processing circuit. This non-volatile memory may store at least one constant, or may store a look-up table for converting the measured impedance value into a magnetic field value, or into a current value, or into a torque value, etc.

In an embodiment according to the third aspect, wherein the excitation circuit is electrically connected to the soft-magnetic component at a first and a second excitation contact (e.g. E1, E2); and wherein the sensing circuit is electrically connected to the soft-magnetic component at a first and a second sensing contact (e.g. 51, S2).

In embodiments of the present invention, the excitation circuit is configured for applying an alternating voltage to the soft-magnetic element, for causing an alternating current to flow through at least a portion of the soft-magnetic element.

In embodiments of the present invention, the excitation circuit is configured for passing an alternating current through the soft-magnetic element, and for measuring an alternating voltage over at least a portion of the soft-magnetic element.

In embodiments of the present invention, the excitation circuit may be configured for applying an AC voltage or an AC current having a frequency in the range from 10 kHz to 2.0 GHz, or in the range from 10 kHz to 500 MHz, or from 100 kHz to 200 MHz, or from 10 kHz to 100 MHz, or from 50 kHz to 500 MHz, or from 100 kHz to 100 MHz, or from 50 kHz to 50 MHz.

In embodiments of the present invention, the sensing circuit is configured for measuring an alternating voltage or for measuring an alternating current flowing through at least a portion of the soft-magnetic element.

In embodiments of the present invention, the first excitation contact (e.g. E1) coincides with the first sensing contact (e.g. S1) and the second excitation contact (e.g. E2) coincides with the second sensing contact (e.g. S2).

In embodiments of the present invention, the first and the second sensing contact (e.g. 51, S2) are situated between the first and the second excitation contact (e.g. E1, E2).

In embodiments of the present invention, the excitation contacts may be situated at least 5% or at least 10% or at least 15% of the length of the elongated portion of the MI-element, from the longitudinal ends of the MI-element.

In embodiments of the present invention, the semiconductor substrate further comprises a buffer layer (e.g. a polyimide layer), and the soft-magnetic component is arranged on top of this buffer layer.

It is an advantage of the buffer layer that it may reduce mechanical stress.

In embodiments of the present invention, the excitation circuit and the sensing circuit are electrically connected to the soft-magnetic component by means of electrical interconnections passing through the buffer layer.

It is an advantage of electrically connecting the soft-magnetic component "from below", which may be referred to as "bottom contact" or "back-contact", because by doing so, an extra processing step of connecting the soft-magnetic component "from above" (e.g. by means of bond wires) can be avoided, and because it is mechanically more stable.

In embodiments of the present invention, the soft-magnetic component has a substantially planer shape with a thickness T of at least 500 nm, or at least 600 nm, or at least 700 nm, or at least 800 nm, or at least 900 nm, or at least 1.0 µm, or at least 1.2 µm, or at least 1.4 µm, or at least 1.6 µm, or at least 1.8 µm, or at least 2.0 µm, or at least 2.5 µm, or at least 3.0 µm, or at least 3.5 µm, or at least 4.0 µm, or at least 4.5 µm, or at least 5.0 µm, or at least 6.0 µm, or at least 7.0 µm, or at least 8.0 µm, or at least 9.0 µm, or at least 10.0 µm, or at least 12.0 µm, or at least 14.0 µm, or at least 16.0 µm, or at least 18.0 µm, or at least 20.0 µm.

In embodiments of the present invention, the soft-magnetic component is at least partially deposited by electroplating, on top of an electrically conductive seed layer. The seed layer may be deposited on top of a polyimide layer.

In embodiments of the present invention, the soft-magnetic component has a substantially planar shape with a mainly circular top view, with a diameter in the range from 100 µm to 300 µm, e.g. in the range from 150 µm to 250 µm.

In embodiments of the present invention, the soft magnetic component has a substantially planar shape with a mainly elliptical top view, or a mainly square top view, or a mainly rectangular top view having a length L and a width W, wherein W ≤ L and W/L is at least 0.25 or at least 0.35 or at least 0.40 or at least 0.45 or at least 0.50.

In embodiments of the present invention, the semiconductor device further comprises biasing means for generating a DC magnetic field in the soft-magnetic component.

This embodiment offers the advantage that the characteristic of impedance versus magnetic field to be measured, can be shifted away from the origin, and the sensitivity can be increased.

In embodiments of the present invention, the biasing means comprises a coil, e.g. a planar coil, implemented in the so called "metal stack" or "interconnection stack" of the semiconductor device, e.g. of the CMOS device. This coil may comprise one or two or three metal layers. The biasing coil may for example be implemented in a similar manner as the transmitter coil described EP3961926(A1), and illustrated in FIG. 8(a) to FIG. 8(d) thereof, which document is incorporated herein by reference in its entirety, but in the current application, preferably supplied with a DC-current.

In embodiments of the present invention, the soft-magnetic component has a cross-section with rounded or truncated edges or corners, for example obtained by etching.

In embodiments of the present invention, the semiconductor substrate further comprises two soft-magnetic trapezoidal shapes arranged near opposite ends (e.g. A, B) of the soft-magnetic element.

In other words, the elongated portion of the soft-magnetic component is arranged between these two trapezoidal shapes.

The trapezoidal shapes may be integrally formed with the soft-magnetic element, in which case the elongated shape contacts the trapezoidal shapes. In this case, preferably, the trapezoidal shapes have the same thickness as the soft-magnetic element. The electrical contacts with the excitation circuit and the sensing circuit may be situated on the trapezoidal shapes, or on the elongated portion, or excitation contacts may be situated on the trapezoidal shapes and the sensing contacts may be situated on the elongated portion.

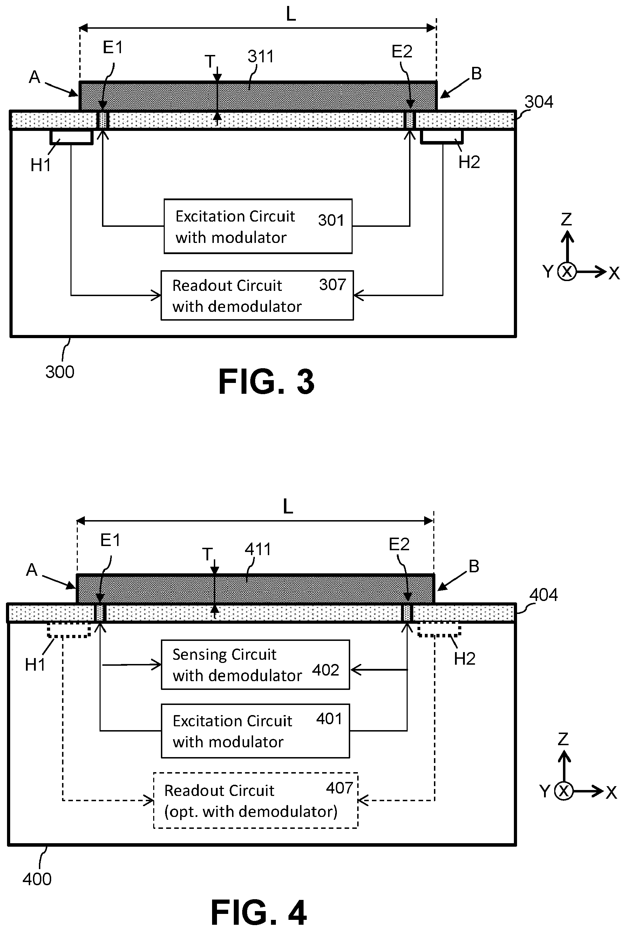

Alternatively, the trapezoidal shapes are spaced from the elongated portion of the soft-magnetic element (e.g. as illustrated in FIG. 4), in which case, there is a small distance between the elongated portion and the trapezoidal shapes.

It is an advantage of this embodiment that the trapezoidal shaped portions function as a magnetic flux concentrator, that the magnetic field component Bx is passively amplified, which further improves the sensitivity of the magneto-impedance measurement, moreover in a passive manner (i.e. without extra power consumption). This is a major advantage, especially for portable applications, such as e.g. an eCompass.

In embodiments of the present invention, the soft-magnetic component has a circular shape; and the semiconductor substrate comprises a plurality of at least two (or at least three, or at least four, or at least six, or at least eight) Horizontal Hall elements arranged near a periphery of the soft-magnetic component; and the soft-magnetic component is electrically connected to the semiconductor substrate by means of a plurality of at least two (or at least three, or at least four, or at least six, or at least eight) electrical contacts (c1, c2).

The number of horizontal Hall elements may be equal to the number of electrical contacts, but that is not absolutely required.

The electrical contacts may be arranged such that they are located on a virtual circle having a radius smaller than the radius of the soft magnetic component. Preferably the radius of the virtual circle on which the contacts are located is at least 50% of the radius of the soft magnetic component, or at least 60%, or at least 70%, or at least 80%, or at least 90%.

The electrical contacts may be located on virtual line segments extending in a radial direction from the centre of the soft magnetic component to respective Hall elements.

The electrical contacts may also be located on virtual line segments extending in a radial direction from the centre of the soft magnetic component to a position between two adjacent Hall elements (i.e. angularly offset from the angular positions of the Hall elements).

In an embodiment, one of the contacts is used to provide an excitation signal, and each of the other contacts is individually sensed in order to detect a defect.

In embodiments of the present invention, the semiconductor device further comprises a second soft-magnetic component (e.g. IMC2); wherein the first soft magnetic component (e.g. IMC1) comprises at least a first and second electrical contact (e.g. c1, c2); wherein the second soft magnetic component (e.g. IMC2) comprises at least a third and fourth electrical contact (e.g. c3, c4); and wherein the second electrical contact (e.g. c2) is electrically connected to the third electrical contact (e.g. c3) in the semiconductor substrate; and wherein the excitation signal is applied to the first electrical contact (e.g. c1), and the sensed signal is obtained from the fourth electrical contact (e.g. c4).

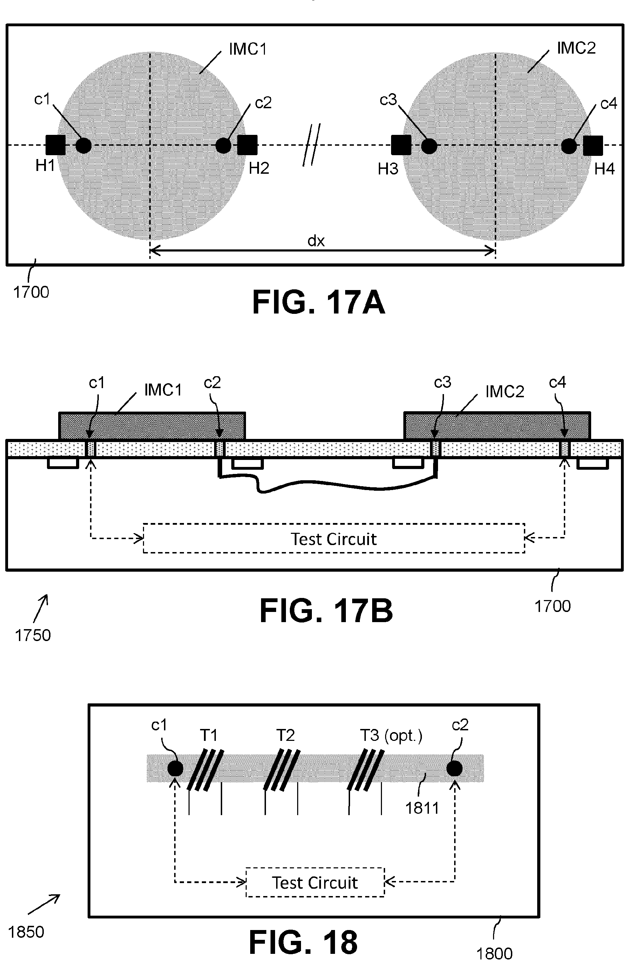

An example of this embodiment is illustrated in FIG. 18A and FIG. 18B. This semiconductor device is capable of detecting a defect (e.g. absence or broken) of any one of the soft magnetic components "in the chain". More than two soft magnetic components may be interconnected in the same way. It is an advantage of this embodiment that the test circuit only requires a single excitation node and a single sense node.

According to a fourth aspect, the present invention also provides a method of producing a semiconductor substrate comprising the steps of: a) providing a semiconductor substrate (e.g. CMOS substrate) comprising electronic circuitry, comprising at least an excitation circuit, and a processing circuit; b) optionally providing a buffer layer (e.g. a polyimide layer) on top of the semiconductor substrate; c) making at least two openings through an upper layer (e.g. protection layer or buffer layer) of the semiconductor substrate, to form excitation contacts and/or sensing contacts in electrical connection with said circuitry; d) optionally providing at least one seed layer (e.g. by sputtering) of an electrically conductive material (e.g. Cu); e) providing a soft-magnetic material (e.g. a thin film of a ferromagnetic material, e.g. FeNi or an Fe-Ni alloy), preferably by sputtering and/or by electroplating, e.g. on top of the seed layer, if present.

In embodiments of the present invention, the method may further comprise one of more of the following features:
- wherein the semiconductor substrate provided in step a) is a CMOS substrate;
- wherein the semiconductor substrate provided in step a) further comprises at least two horizontal Hall elements, and a biasing and readout circuit;
- wherein the method further comprises: providing at least one seed layer (e.g. by sputtering) of an electrically conductive material (e.g. Cu);
- wherein the semiconductor substrate provided in step a) further comprises a buffer layer on top of the semiconductor substrate;
- further comprising a step of wet etching or anisotropic etching after applying the soft-magnetic material, in order to provide rounded or truncated ends and/or edges;
- wherein the method further comprises step f) of annealing (2136) the soft-magnetic material while applying a static magnetic field oriented in a direction parallel to the semiconductor substrate;
- wherein the method further comprises a step of creating an easy magnetization axis by flowing a relatively large current through the soft-magnetic component during a predefined time.

According to a fifth aspect, the present invention also provides a method of process-control which can be used during production of semiconductor substrates comprising a soft-magnetic material, e.g. as specified in the first, second or third aspect mentioned above, wherein the method of process-control comprises the steps of: i) generating, by a test system outside of the semiconductor substrate, a test voltage and applying the test voltage to voltage nodes connected to the back contacts or side contacts of the soft-magnetic component; ii) measuring, by the test system, a resulting test current in response to said test voltage; iii) testing whether the resulting test current is smaller than a first predefined threshold and/or larger than a second predefined threshold, and detecting a problem based on an outcome of this one or more comparisons.

It is an advantage that these steps can be performed by a test system, outside of the semiconductor substrate under test. step iii) may be performed on a digital processor of such a test system, which is external of the semiconductor substrate.

According to a sixth aspect, the present invention is also directed to a test-system operatively connected to a semiconductor device comprising a soft-magnetic material, e.g. as specified in the first, second or third aspect, and configured for performing a method of process-control according to the fifth aspect.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1** shows an embodiment of a semiconductor substrate with a soft magnetic component, e.g. a magneto-impedance (MI) element integrally formed on top of the semiconductor substrate, according to an embodiment of the present invention.
**FIG. 2** shows a variant of the embodiment of FIG. 1, wherein the first sensing contact coincides with the first excitation contact, and wherein the second sensing contact coincides with the second excitation contact, according to an embodiment of the present invention.
**FIG. 3** shows an embodiment of a semiconductor substrate with a soft magnetic component and electromagnetic transducers arranged near ends or near the periphery of the soft-magnetic component, and circuitry for applying a modulated signal to the soft magnetic component, and circuitry for reading and demodulating signals obtained from the electromagnetic transducers, as another embodiment of the present invention.
**FIG. 4** shows a variant of the embodiment of FIG. 3, further comprising a sensing circuit for use of the soft magnetic component as an active component, e.g. as an MI element. The demodulator may be used to demodulate the signals obtained from the sensing circuit, and/or to demodulate the signals obtained from the readout circuit.
**FIG. 5** shows a semiconductor substrate, e.g. a CMOS substrate with electronic circuitry (not shown) and with a soft-magnetic component, electrically connected to the circuitry via "back-contacts" or "bottom contacts".
**FIG. 6** shows a semiconductor substrate, e.g. a CMOS substrate with electronic circuitry (not shown) and with a soft-magnetic component, electrically connected to the circuitry via "side-contacts".
**FIG. 7** is a schematic representation of a semiconductor device having a soft magnetic component, and an excitation circuit and a sensing circuit, configured for detecting (e.g. in a diagnostic mode) a defect of the soft-magnetic component, e.g. broken or (partially) peeled off.
**FIG. 8** shows a variant of FIG. 7, further comprising one or more electromagnetic transducers (e.g. Hall elements or coils) arranged in the vicinity of the soft-magnetic component, and operatively connected thereto.
**FIG. 9** shows a variant of FIG. 8, wherein the sensing contacts coincide with the excitation contacts, and the semiconductor device further comprises a modulator for modulating the magnetic permeability of the soft-magnetic material, and a demodulator for demodulating the signals obtained from the one or more electromagnetic transducers.
**FIG. 10** shows another variant of FIG. 8, further comprising a modulator for modulating the magnetic permeability of the soft-magnetic material, and a demodulator for demodulating the signals obtained from the sensing circuit.
**FIG. 11(a)** shows a top view, and **FIG. 11(b)** shows a side view of an example or a variant of FIG. 8, wherein the sensing contacts coincide with the excitation contacts, and wherein the soft-magnetic component is a magneto-inductive (MI) element having an elongated shape extending in the X-direction, and wherein two horizontal Hall elements are located near the longitudinal ends of the MI-element.
**FIG. 12(a)** shows a top view, and **FIG. 12(b)** shows a side view of a variant of FIG. 11(a) and FIG. 11(b) wherein the soft-magnetic component is an integrated passive flux concentrator (IMC) having a disk shape, and wherein two horizontal Hall elements are located near a periphery of the IMC.
**FIG. 13** is a simplified representation of a semiconductor device as illustrated in FIG. 12(a) and FIG. 12(b) or variants thereof, having two electrical contacts and two Horizontal Hall elements, angularly spaced by 180°.
**FIG. 14** shows a variant of FIG. 13, where the electrical contacts are also located at a second radius smaller than the first radius, but the angular positions of the electrical contacts are angularly offset from the angular positions of the horizontal Hall elements.
**FIG. 15** shows another variant of FIG. 13, wherein four horizontal Hall elements are arranged near the periphery of the disk shaped soft-magnetic component, and wherein four electrical contacts are arranged in close proximity to a corresponding Hall element.
**FIG. 16** shows a variant of FIG. 15, wherein the positions of the four electrical contacts are angularly offset with respect to the positions of the Hall elements, in the example by 45°.
**FIG. 17A** shows a top view, and **FIG. 17B** shows a side view of an illustrative semiconductor substrate having two soft-magnetic components, spaced apart from each other.
**FIG. 18** is a schematic representation of a semiconductor substrate comprising a passive soft-magnetic component in the form of an integrated fluxgate.
**FIG. 19** shows a semiconductor substrate with a soft-magnetic structure comprising a central disk and twelve radially oriented segments, angularly spaced by multiples of 360°/12=30°.
**FIG. 20** shows a variant of FIG. 19 where the Hall elements are situated near an inner end of the radially oriented segments.
**FIG. 21** to **FIG. 23** shows flow-charts of methods to make a semiconductor substrate with a soft-magnetic component, connected to circuitry of the semiconductor substrate by means of back-contacts or side contacts.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

The terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, unless explicitly mentioned otherwise, the term "magnetic sensor device" refers to a device comprising at least one "magnetic sensor" or at least one magnetic "sensor element", preferably integrated in a semiconductor substrate. The sensor device may be comprised in a package, also called "chip", although that is not absolutely required.

In this document, the term "magnetic sensor element" or "magnetic sensor" can refer to a component or a group of components or a sub-circuit or a structure capable of measuring a magnetic quantity, such as for example a magneto-resistive (MR) element, a GMR element, an XMR element, a horizontal Hall plate, a vertical Hall plate, a Wheatstone-bridge containing at least one (but preferably four) magneto-resistive elements, a magneto-impedance (MI) element, a giant magneto-impedance (GMI) element, etc. or combinations hereof.

In embodiments of the present invention, the term "magnetic sensor structure" may refer to a single "magnetic sensor element", or to an arrangement comprising at least two "magnetic sensor elements", e.g. one or more horizontal Hall elements and optionally one or more integrated magnetic flux concentrators (IMC).

In this document, the expression "in-plane component of a magnetic field vector" and "projection of the magnetic field vector in the sensor plane" mean the same. If the sensor device is or comprises a semiconductor substrate, this also means a "magnetic field component parallel to the semiconductor plane". These components may be labelled Bx, By.

In this document, the expression "out-of-plane component of a magnetic field vector" and "Z component of the vector" and "projection of the vector on an axis perpendicular to the sensor plane" mean the same. This component may be labelled Bz.

Embodiments of the present invention are typically described using an orthogonal coordinate system which is fixed to the sensor device, and having three axes X, Y, Z, where the X and Y axis are parallel to the substrate, and the Z-axis is perpendicular to the substrate.

In this document, the expression "magneto-impedance component" or "magneto-impedance element" are used as synonyms.

In this document, the expression "spatial derivative" or "derivative" or "spatial gradient" or "gradient" are used as synonyms. If the order of the derivative is not explicitly mentioned, a first order gradient is meant, unless clear from the context otherwise. In the context of the present invention, the gradient is typically determined as a difference between two values measured at two locations spaced apart along a certain direction. In theory the gradient is typically calculated as the difference between two values divided by the distance between the sensor locations, but in practice the division by said distance is often omitted, because the measured signals need to be scaled anyway. Hence, in the context of the present invention, the expression "magnetic field difference" and "magnetic field gradient" can be used interchangeably.

In this application, horizontal Hall plates are typically referred to by H1, H2, etc., signals obtained from horizontal Hall plates are typically referred to by h1, h2, etc., vertical Hall plates are typically referred to by V1, V2, etc., and signals obtained from vertical Hall plates are typically referred to by v1, v2, etc.

The expression "soft-magnetic material" is well known in the art of magnetic materials. Soft-magnetic materials are materials that are easily magnetised and demagnetised. They may typically have intrinsic coercivity less than 1000 Am-1, e.g. between 0.1 and 10 Am-1. They are used primarily to enhance and/or channel the flux.

With "soft-magnetic component " is meant that a component or element that consists of, or mainly comprises a soft-magnetic material, e.g. an element made of an FeNi alloy. Unless explicitly mentioned otherwise, the "soft-magnetic component" may be used as a magneto-resistive (MR) element, a magneto-impedance (MI) element, a passive magnetic flux concentrator (e.g. an IMC or a transformer core), or an integrated fluxgate.

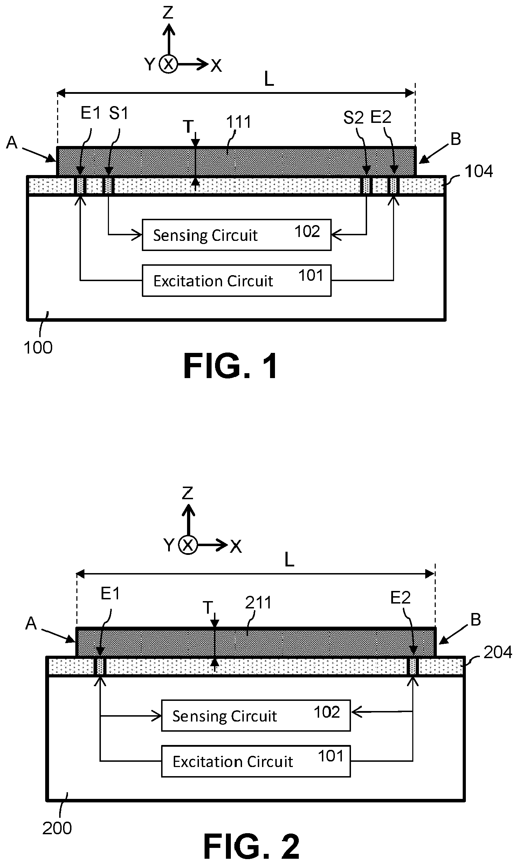

The "back contacts" may also be referred to as "bottom contacts". They are situated at a bottom surface of the soft-magnetic component (e.g. as shown in FIG. 1 to FIG. 4 and FIG. 8). The "side contacts" are situated near a lateral surface of the soft magnetic component (e.g. as shown in FIG. 9).

The present invention relates to the field of semiconductor devices comprising a semiconductor substrate, e.g. a CMOS substrate, comprising a soft-magnetic component, meaning a piece of a soft-magnetic material, e.g. comprising or consisting of FeNi or a Nickel-Iron alloy. In the context of the present invention, the soft-magnetic component is a "thin film material", preferably having a thickness T in the range from about 500 nm to about 20.0 µm, which is deposited on, or partially embedded in a semiconductor substrate. The soft-magnetic component has a substantially planar shape, preferably a solid shape (i.e. completely filled, not a hollow object).

Semiconductor devices comprising an active soft-magnetic component (i.e. wherein the soft-magnetic component is electrically connected to circuitry), or a passive soft-magnetic component (i.e. wherein the soft-magnetic component is left floating), are known in the art. Examples of devices with an active soft-magnetic component are devices with a magneto-resistive (MR) component, or with a magneto-impedance (MI) component.

Examples of devices with a passive soft-magnetic component are integrated fluxgates, integrated voltage-and-current transformers, magnetic sensor devices with Hall elements and a flux concentrator (IMC).

As used herein, the "normal function" or "standard function" of an MR element is to measure (directly or indirectly) an electrical resistance of the MR element in the presence of a magnetic field, which resistance varies due to the magneto-resistive effect, and is indicative of a characteristic of the magnetic field.

As used herein, the "normal function" or "standard function" of an MI element is to measure (directly or indirectly) an electrical impedance of the MI element in the presence of a magnetic field, which impedance varies due to the skin effect, and is indicative of a characteristic of the magnetic field.

As used herein, the "normal function" or "standard function" of a passive soft-magnetic material, such as e.g. an integrated magnetic concentrator (IMC) located near a Hall element, or a magnetic core located near one or more coils, is to guide magnetic flux lines.

Circuits for interfacing with MR elements, MI elements, horizontal Hall elements, vertical Hall elements, and coils, i.e. circuits for providing an energy signal to, and circuits for obtaining a readout signal from such elements, are known in the art, are not the main focus of the present invention, and hence need not be described in more detail here.

**FIG. 1** show a cross-section of a semiconductor substrate 100, and a magneto-impedance element 111 integrally formed on top of the semiconductor substrate 100. The magneto- impedance element 111 is also referred to herein as MI-element or MI-component.

The MI-element 111 of FIG. 1 has an elongated shape extending in a first direction X, parallel to the semiconductor substrate. The X-direction is also referred to as the "longitudinal direction". A second axis Y, also referred to herein as "transversal direction" or "width direction" is oriented parallel to the substrate 100 and perpendicular to the X-axis. A third axis Z, also referred to herein as "height direction" is oriented perpendicular to the substrate 100.

In preferred embodiments, the semiconductor substrate 100 (without the MI-element) is a "CMOS device", i.e. is produced using a CMOS compatible process. The semiconductor substrate 100 comprises an excitation circuit 101, and a sensing circuit 102 for measuring (directly or indirectly) a magneto-impedance effect of the MI-element 111. Such circuits are known in the art, are not the main focus of the present invention, and hence need not be explained in full detail here. It suffices to say that the excitation circuit 101 may be configured to generate an alternating voltage signal or a pulsed voltage signal, e.g. a sinusoidal voltage signal having a predefined amplitude and a predefined frequency, or to generate an alternating current signal or a pulsed current signal, e.g. a sinusoidal current signal having a predefined amplitude and a predefined frequency. The frequency may be in the range from 10 kHz to 2.0 GHz, or in the range from 10 kHz to 500 MHz, or from 100 kHz to 200 MHz, or from 10 kHz to 100 MHz, or from 50 kHz to 500 MHz, or from 100 kHz to 100 MHz, or from 50 kHz to 50 MHz.

The semiconductor substrate 100 may further comprise a processing circuit (not explicitly shown in FIG. 1, but see e.g. FIG. 7 to FIG. 10) connected to the sensing circuit 102, and configured for providing a signal indicative of the measured impedance or a value derived therefrom, e.g. a magnitude of a magnetic field component Bx, a current value, a torque value, a linear or an angular position, a distance value, etc.

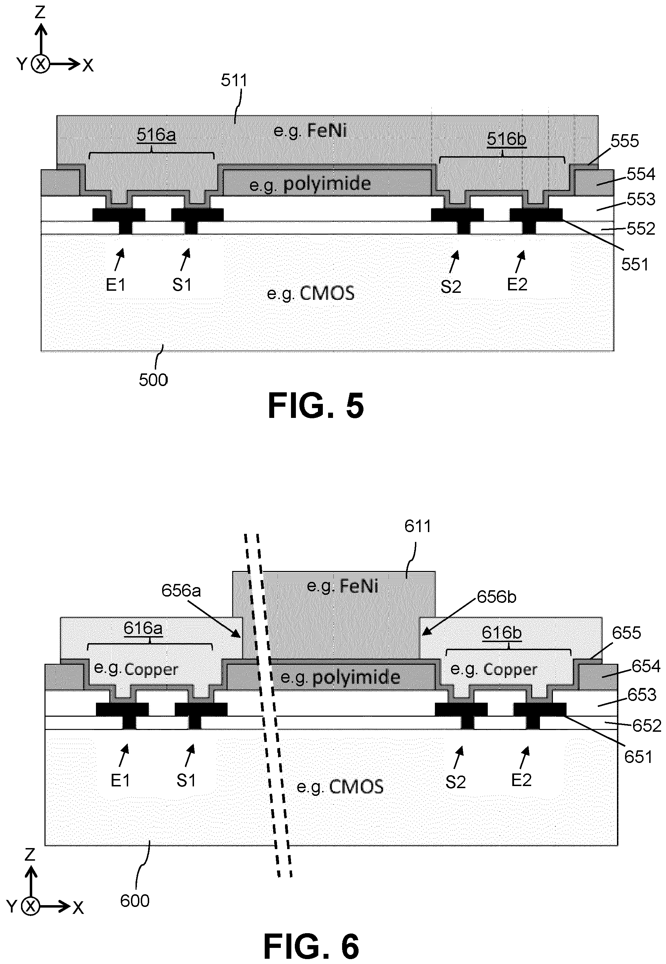

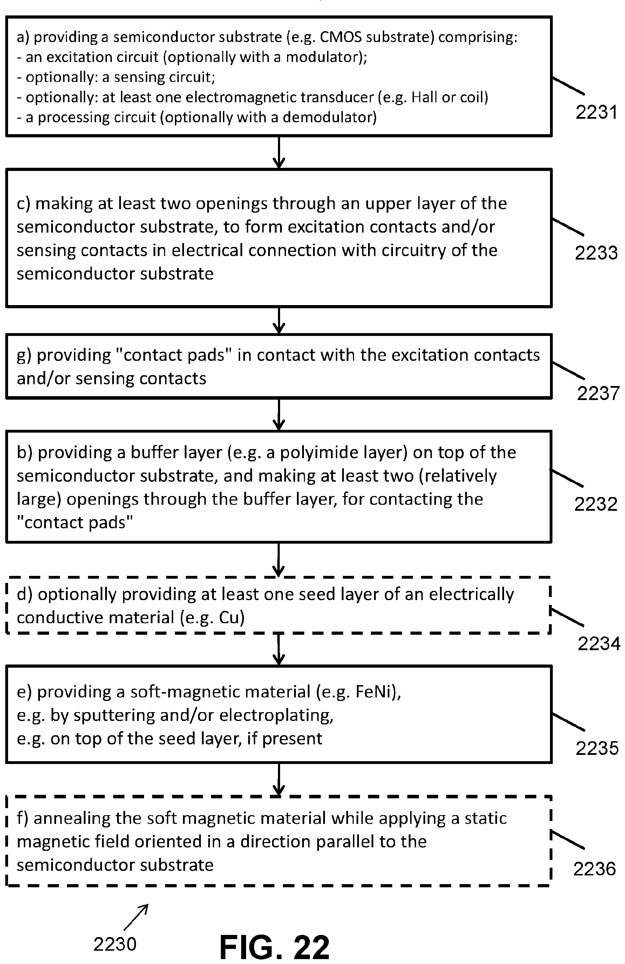

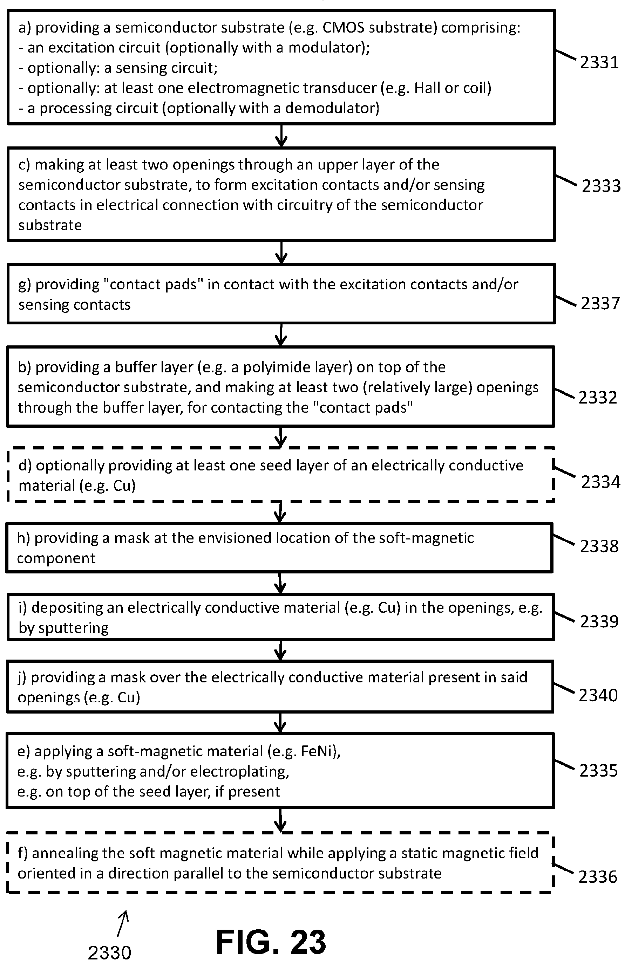

According to underlying principles of the present invention,
- the MI-element 111 mainly comprises a soft-magnetic material, or is made of a soft-magnetic material, e.g. a ferromagnetic material, e.g. FeNi or an Fe-Ni alloy;
- the MI-element 111 is arranged, e.g. deposited on top of the semiconductor substrate 100, e.g. directly on top of the semiconductor substrate, or on top of a buffer layer 104, e.g. a polyimide layer. Typically, a plurality of openings need to be made in the CMOS substrate, and if a buffer layer 104 is also present, the plurality of openings also needs to be made in the buffer layer, e.g. by etching. The MI element 111 may be applied by sputtering and/or by electroplating. The "metal stack" of the CMOS substrate (not explicitly shown) may contain a plurality of patterned metal layers, typically four layers, separated by silicon dioxide (SiO₂). The metal stack may further contain an electrically conductive "seed layer" functioning both as an etch stop, and as a basis for growing the soft-magnetic material. Alternatively, a seed layer may be sputtered on top of the CMOS substrate. The dimensions of the MI-element 111 may be defined by lithographical processes. The thickness of the MI element 111 may be defined by the duration of the sputtering or electroplating step, or in other suitable ways. It is noted that a seed layer is needed only when the soft-magnetic material is deposited by electroplating, but the present invention is not limited thereto. If the soft-magnetic material is deposited only by sputtering, the seed layer may be omitted.
- the MI element 111 is electrically connected to said excitation circuit 101 and to said sensing circuit 102 by means of at least two (e.g. only two, or four) electrical contacts E1, 51, E2, S2. In FIG. 1 these contacts are situated at a bottom side of the MI element 111, in which case they are also referred to herein as "back contacts" or "bottom contacts" (see FIG. 5 and FIG. 22 for a possible implementation), but the present invention is not limited thereto, and it is also possible to connect the MI-element to the excitation circuit and the sensing circuit via "side-contacts" (see FIG. 6 and FIG. 23 for a possible implementation). In this way, electrical connections at the top, e.g. by means of bond wires can be avoided, thus extra processing steps can be avoided. Furthermore, the "back-contacts" or "side contacts" also provide a very firm mechanical anchoring of the MI-element, such that the risk of delamination is strongly reduced.

The semiconductor substrate 100 with the MI-element 111 may be mounted on a lead frame (not shown), and/or may be overmoulded by a moulding compound (not shown), so as to form a packaged sensor device, also referred to as "chip".

The excitation circuit 101 of FIG. 1 is electrically connected to the MI-element 111 by means of two "bottom contacts" or "back-contacts" E1, E2, spaced apart over a first non-zero distance along the X-direction. The sensing circuit 102 is electrically connected to the MI-element 111 by means of two "bottom contacts" or "back-contacts" 51, S2, spaced apart over a second non-zero distance along the X-direction. The second distance may be smaller than the first distance, or may be equal to the first distance, e.g. in case the excitation contacts and the sensing contacts coincide (e.g. as illustrated in FIG. 2). The second distance may be at least 150 µm, or at least 200 µm, or at least 250 µm, or at least 300 µm, or at least 400 µm, or at least 500 µm, or at least 750 µm, or at least 1000 µm.

In the example of FIG. 1, the sensing contacts S1, S2 are located between the excitation contacts E1, E2, but that is not absolutely required, because the sensing contact 51 and the excitation contact E1 may coincide. Likewise, the sensing contact S2 and the excitation contact E2 may coincide. Thus, the MI-element 111 may have two back contacts or side contacts (if S1 coincides with E1, and S2 coincides with E2), or three back contacts or side contacts (e.g. if S1 coincides with E1, but 52 does not coincide with E2) or four back contacts or side contacts (e.g. if S1 and E1 are separate contacts, and S2 and E2 are separate contacts).

The excitation contacts E1, E2 may be offset from the outer ends A, B of the soft-magnetic element 111 in the longitudinal direction, e.g. at least L*3%, or at least L*5%, or at least L*10%, or at least L*15%, where L is the length of the MI-element in the longitudinal direction. In this way, the risk of a non-uniform current density due to side effects and/or surface defects near the edges or near the outer ends of the MI-structure, can be reduced or avoided.

The MI-element 111 may be beam-shaped with a length L in the X-direction (longitudinal direction), a width W in the Y-direction (transversal direction), and a height H in the Z-direction (height direction).

In an embodiment, at least one of the ratios L/W and T/W is a value in the range from 5 to 20, e.g. in the range from 8 to 18, e.g. in the range from 10 to 15.

In some embodiments, both ratios L/W and T/W are in the range from 5 to 20. This is beneficial for the skin effect, and thus for the impedance measurement.

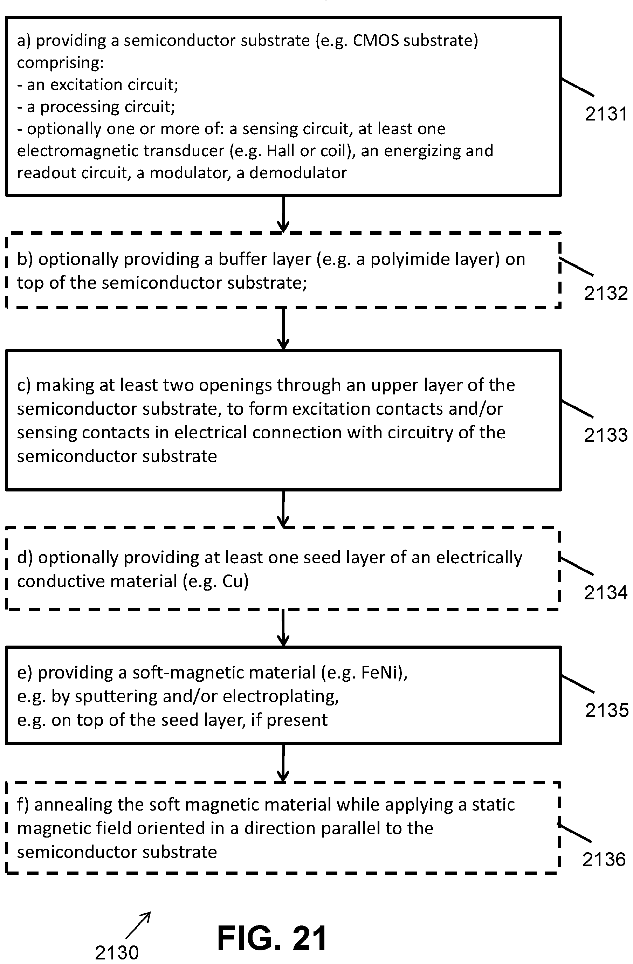

A method which can be used to produce a sensor device with a semiconductor substrate as illustrated in FIG. 1, will be provided in FIG. 21.

The MI-element of FIG. 1 may be used in its "normal way", e.g. be flowing a known current through the MI-element injected via the excitation contact E1 and extracted via the contact E2, and by measuring a voltage over the sensing contacts S1, S2. As far as is known to the inventors, an integrated MI-element with back-contacts or side-contacts is not known in the art.

In a variant (not shown), the MI element 211 has rounded or truncated ends, and/or has rounded or truncated edges. This can be achieved for example by wet etching. By providing rounded or truncated edges and/or rounded or truncated ends, discontinuities in the current density near the outer periphery of the MI-element can be avoided, which may be beneficial for the MI-effect.

The inventors also came to the idea that the sensed signals can also be used to verify if the soft-magnetic component is (still) present, is not broken or peeled off. This can be implemented e.g. by testing if the measuring current is higher than a predefined threshold. In fact, this diagnostic test is very useful as a safety check, not only for MI-elements, but also for other soft-magnetic components, as will be described further.

**FIG. 2** shows a semiconductor substrate 200 which is a variant of FIG. 1, wherein the first sensing contact 51 coincides with the first excitation contact E1, and wherein the second sensing contact S2 coincides with the second excitation contact E2. Everything else described above, is also applicable here.

**FIG. 3** shows a semiconductor substrate 300 with a soft-magnetic component 311 and with electromagnetic transducers (in the example of FIG. 3: two horizontal Hall elements, H1, H2) arranged near ends of the (e.g. elongated shaped) soft-magnetic component 311 or near the periphery of the (e.g. circular shaped) soft-magnetic component 311, and circuitry 301, 302 for applying a modulated signal to the soft magnetic component 311, and circuitry 307 for reading and demodulating signals obtained from the electromagnetic transducers H1, H2. In this embodiment, the soft-magnetic component 311 is primarily used to guide flux lines, but its permeability is varied.

The modulation circuit 301 may generate a modulated signal, e.g. a voltage or a current signal in the form of a sinusoidal wave having a predefined amplitude and frequency, or a square wave with a predefined amplitude and frequency, or a PWM signal (pulse-width modulation) having a predefined duty cycle and a predefined amplitude and a predefined period, or another type of modulation. In this way, the magnetic permeability of the soft-magnetic component 311 can be changed.

The readout circuit 307 with demodulator is configured for demodulating the signals obtained from the transducers, e.g. the Hall elements H1, H2. Preferably the demodulation is synchronous with the modulation, e.g. using a same clock reference (not explicitly shown).

In an embodiment, the modulation is not fixed, but e.g. one or more of the frequency, the amplitude, the duty cycle, the dc component of modulation signal is varied.

**FIG. 4** shows a semiconductor substrate 400 which can be seen as a variant of FIG. 3, further comprising a sensing circuit 402 for measuring and demodulating a response signal obtained from the soft-magnetic component 411. This soft-magnetic component may for example be designed (material and shape and size) as an MR element or as an MI element.

In an embodiment, the readout circuit 407 and the Hall elements H1, H2 are omitted.

In an embodiment, the readout circuit 407 and the Hall elements H1, H2 are present, and this same soft-magnetic component 411 is also used as a flux-guide for guiding flux lines to the electromagnetic transducers H1, H2 (e.g. horizontal Hall elements). The Hall elements H1, H2 may be read-out while the excitation circuit 401 is disabled or disconnected from the soft-magnetic component. Alternatively, the Hall elements H1, H2 may be read-out while the excitation circuit 401 is active and applying a modulated signal to the soft-magnetic material, to thereby modulate its magnetic sensitivity.

**FIG. 1** to **FIG. 4** illustrate several aspects or principles which may be applied also in other devices having a soft-magnetic component, and several of these aspects which also may be combined. Some examples will be described further.

**FIG. 5** shows a cross-sectional view of a semiconductor device 500, e.g. a CMOS substrate, with a soft-magnetic component 511 electrically connected to circuitry of the semiconductor substrate 500 via openings 516a, 516b through a polyimide layer 554 on top of which the soft-magnetic element 511 is situated. In the example shown in FIG. 5, each opening 516a, 516b accommodates an excitation contact E1, E2 and a sense contact S1, S2. The opening is substantially filled with the soft-magnetic material. This technique may be used to provide a soft-magnetic component having "back contacts" or "bottom contacts", not only for an MI-component, but also for a passive soft-magnetic component (e.g. a disk shaped IMC), or a soft-magnetic core of an integrated transformer, or the soft-magnetic core of an integrated fluxgate, e.g. for enabling detection of a mechanical problem (e.g. broken or peeled off).

The main purpose of FIG. 5 is to show how a soft-magnetic component 511 can be electrically connected to circuitry of a semiconductor substrate by means of "back contacts".

A method to produce a semiconductor substrate as illustrated in FIG. 5, will be described further in FIG. 21 and FIG. 22, but as can already be appreciated from FIG. 5, the semiconductor substrate 500 may be based on a CMOS device with a passivation layer 552 and with contact pads 551. On top of the CMOS substrate a buffer layer 554, e.g. a polyimide layer is applied; a first relative large opening 516a is made in the buffer layer above the contact pads E1, 51, and a second relatively large opening 516b is made in the buffer layer above the contact pads E2, S2, and four relatively small openings are made to expose the contact pads 551. Then a conductive seed layer 555 may be sputtered, and a soft magnetic material (e.g. FeNi or a FeNi alloy) may be applied on top of the seed layer, e.g. by electroplating. As can be seen, the relatively large openings are thus mainly filled with the soft-magnetic material 511, and the soft-magnetic component 511 thus formed, has four "back contacts" or "bottom contacts".

It is an advantage that the contact pads 511 are made by the CMOS process (with high position accuracy), and that the position tolerances of the opening 516a, 516b through the buffer layer 554 can be relaxed.

No electrical circuits are shown in the semiconductor substrate of FIG. 5, but for example any of the circuits shown FIG. 1 to FIG. 4 can be used, and other components, such as e.g. Hall plates or coils may also be added, e.g. planar coils under the soft-magnet component, or coils wound around the soft-magnetic component (e.g. using electrical tracks underneath and bond wires above).

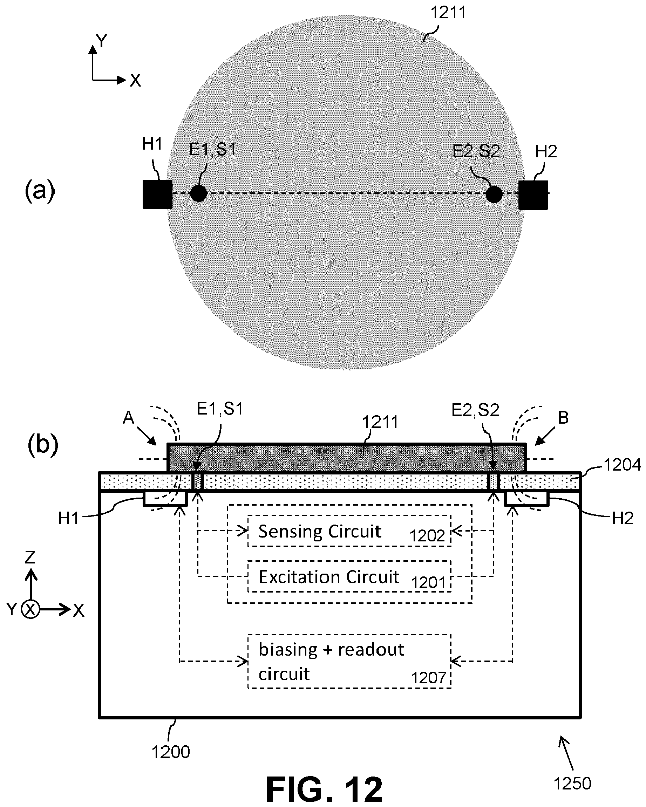

In a particular example, the soft-magnetic component 511 is a circular disk, and the semiconductor substrate further comprises a plurality of horizontal Hall elements arranged near the periphery of that disk, for example, as also illustrated in FIG. 12 to FIG. 17B and FIG. 19.

In a variant (not shown), the sensor contact 51 coincides with the excitation contact E1, and the sensor contact S2 coincides with the excitation contact E2.

**FIG. 6** shows a semiconductor substrate 600, e.g. a CMOS substrate with electronic circuitry (not shown in FIG. 6, but see e.g. FIG. 1 to FIG. 4 and FIG. 7 to FIG. 10, etc.), and with a soft-magnetic component 611 electrically connected to said circuitry of the semiconductor substrate via "side-contacts". The substrate 600 of FIG. 6 can be seen as a variant of the substrate 500 of FIG. 5.

A method to produce a semiconductor substrate 600 as illustrated in FIG. 6 will be described further in FIG. 21 and FIG. 23, but as can already be appreciated from FIG. 6, the semiconductor substrate 600 may be based on a CMOS device with a passivation layer 652 and with contact pads 651. On top of the CMOS device a buffer layer 654, e.g. a polyimide layer is applied; a first relative large opening 616a, 616b is made in the buffer layer 654 above the contact pads E1, 51, and a second relatively large opening is made in the buffer layer 654 above the contact pads E2, S2, and four relatively small openings are made to expose the contact pads 651. Then a conductive seed layer 655 may be sputtered. In contrast to the device of FIG. 5, the soft magnetic material is not applied yet, but first a mask is applied to cover a region between the two relatively large openings 616a, 616b, and the openings are mainly filled with a conductive material, such as e.g. copper (Cu). Then the material in the intermediate region is removed, and a soft magnetic material (e.g. FeNi or a FeNi alloy) is applied, on top of the seed layer, e.g. by electroplating. As can be seen, the relatively large openings are thus mainly filled with the non-magnetic material (e.g. Cu), and the soft-magnetic component 611 thus formed may have two or more side contact surfaces 656a, 656b. In this way, the direction of a current flowing through the soft-magnetic material in some embodiments of the present invention, can be better controlled, and the current can be made more uniform.

In a variant of FIG. 6, the sensing contact 51 may coincide with the excitation contact E1, and the sensing contact S2 may coincide with the excitation contact E2.

In another or a further variant, the substrate of FIG. 6 contains a plurality of side-contacts adjacent the soft-magnetic component 611, and these side-contacts are electrically interconnected in the CMOS-device below the soft-magnetic component, and copper zones may be provided on top of each such side contact, and the copper zones may then also be interconnected above the soft-magnetic component, e.g. using an RDL-layer, or using bond-wires. In this way, one or more coils can be formed around the soft-magnetic component.

**FIG. 7** is a schematic representation of a semiconductor device 750 having a soft magnetic component 711, and an excitation circuit 701 and a sensing circuit 702, and a processing circuit 706, the device being configured for detecting (e.g. in a diagnostic mode) a defect of the soft-magnetic component, e.g. broken or (partially) peeled off. This diagnostic function can be added to any existing semiconductor device having an active or passive soft-magnetic component, e.g. can be added to any of the circuits of FIG. 2 to FIG. 4 and variants thereof. The soft-magnetic component may be any one of an MR element, an MI element, an IMC, an integrated fluxgate, a magnetic core of an integrated transformer, etc.

A specific example with two integrated magnetic concentrators with Hall elements and this "detection function" is illustrated in FIG. 17A and FIG. 17B. Another specific example of an integrated fluxgate with this "detection function" is illustrated in FIG. 18.

The excitation circuit may be configured to generate a DC signal or an AC signal. The processing circuit 706 may be configured to output a signal indicative of the defect. In a particular embodiment, an electrical resistance or an impedance of the soft-magnetic component is compared with a predefined threshold value, and if the resistance or impedance is larger than the threshold value, an error is detected. This fault-detection may not be the sole function of the semiconductor device. Indeed, the semiconductor device may have multiple modes of operation, may have additional circuitry, and may have additional components, such as e.g. two or more Hall elements near a periphery of the soft-magnetic component 711, or such as e.g. two or more coils arranged near or around the soft-magnetic component 711. In the example of FIG. 7, the processing circuit may also output another signal or value, e.g. an impedance, a magnetic field value, a current, a torque, a linear or angular position.

In a variant (not shown), the first sensing contact 51 may coincide with the first excitation contact E1, and the second sensing contact S2 may coincide with the second excitation contact E2.

The contacts may be implemented as "back contacts" and/or "side contacts", e.g. as illustrated in FIG. 5 and/or FIG. 6.

FIG. 7 may be seen as a variant or a more detailed version of FIG. 1 and FIG. 2, and as a subset of FIG. 4.

FIG. 8 shows a semiconductor device 850, which can be seen as a variant of the semiconductor device 750 of FIG. 7. The main difference is that the device 850 further comprises one or more electromagnetic transducers T1, T2 (e.g. Hall elements or coils) arranged in the vicinity of the soft-magnetic component 811, and operatively connected thereto.

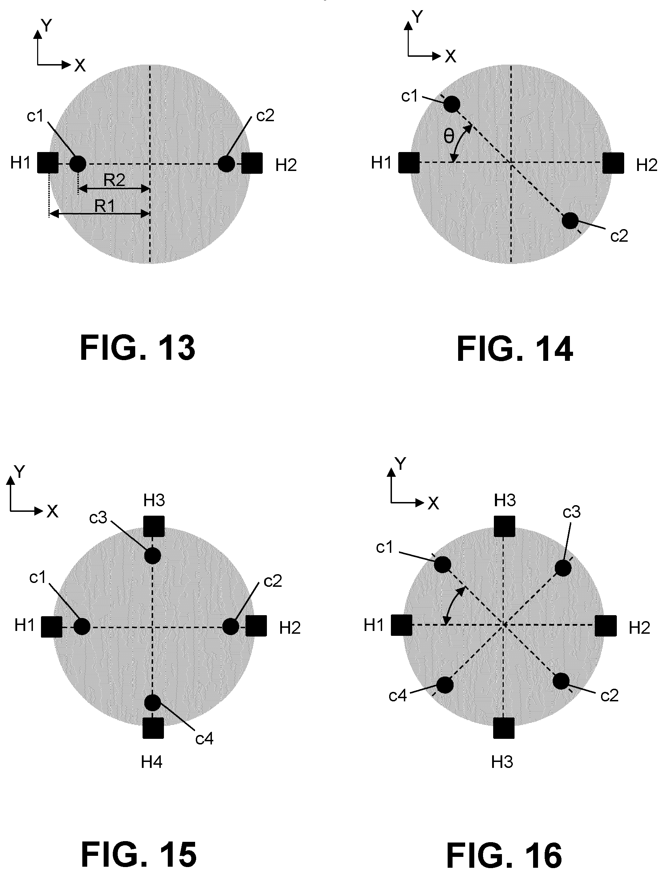

In a specific embodiment, the soft-magnetic component 811 is an IMC, and the transducers are Horizontal Hall elements arranged near a periphery of the IMC. In this case, the "energizing and readout circuit" 807 is typically referred to as a "biasing and readout" circuit. Of course, the semiconductor substrate may comprise more than two Horizontal Hall elements as also illustrated e.g. in FIG. 15, FIG. 16, FIG. 19, FIG. 20.

In another specific embodiment, the soft-magnetic component 811 is an integrated fluxgate, and the transducers T1, T2 are coils, e.g. spiral coils arranged near opposite ends of the soft-magnetic component 811, or coils wrapped around the soft-magnetic component. In this case, the "energizing and readout circuit" 807 may also be referred to as "transmitter circuit" and "receiver circuit". Of course, there may be more than two coils, e.g. as illustrated in FIG. 18, where the first coil T1 may be referred to as "excitation coil", the second coil T2 may be referred to as "pick-up coil", and the third (optional) coil T3 may be referred to as "biasing coil".

This semiconductor device 850 may have two modes of operation, e.g. a first mode (e.g. diagnostic mode) for detecting a defect of the soft-magnetic component 811 mainly using the circuits 801 and 802; and a second mode wherein the soft-magnetic component may be left floating, while signals are obtained from the transducers T1, T2.

**FIG. 9** shows a semiconductor device 950, which can be seen as a variant of the semiconductor device 850 of FIG. 8, wherein the sensing contacts S1, 52 coincide with the excitation contacts E1, E2 respectively, and wherein the semiconductor device 950 further comprises a modulator for modulating the magnetic permeability of the soft-magnetic material, e.g. as part of the excitation circuit 901, and further comprises a demodulator 917, e.g. following the readout circuit 907 for demodulating the signals obtained from the one or more electromagnetic transducers T1, T2.

The modulation may be AM modulation or FM modulation, or other suitable types of modulation. Preferably "synchronous demodulation" is used. The sensing circuit 802 of FIG. 8 may be present (e.g. for detecting a defect of the soft-magnetic component), or may be omitted.

In a specific example, the soft-magnetic component 911 may be an IMC and the transducers T1, T2 may be horizontal Hall elements. In another specific example, the soft-magnetic component 911 may be an integrated fluxgate and the transducers T1, T2 may be coils.

**FIG. 10** shows a semiconductor device 1050, which can be seen as another variant of the semiconductor device 850 of FIG. 8, wherein the semiconductor device 1050 further comprises a modulator for modulating the magnetic permeability of the soft-magnetic component 1011, e.g. as part of the excitation circuit 1001, and further comprises a demodulator 1017, e.g. following the sensing circuit 1002 for demodulating the signals obtained from the sensing circuit 1002. The one or more electromagnetic transducers T1, T2 and the "energizing and readout circuit" 807 of FIG. 8 may be present, or may be omitted.

The soft-magnetic component 1011 may be a magneto-resistive (MR) component or a magneto-inductive (MI) component, e.g. having an elongated shape. The optional horizontal Hall elements may be located near the ends of the soft-magnetic component. The output signal provided by the processing circuit 1006 may be related to a magnetic field strength measured by the soft-magnetic component 1011.

It is noted that the processing circuit in any of FIG. 7 to FIG. 10 may be partially implemented fully or partially in the analog domain and in the digital domain. The processing circuit may comprise an analog-to-digital convertor, a programmable processor, a non-volatile memory, etc.

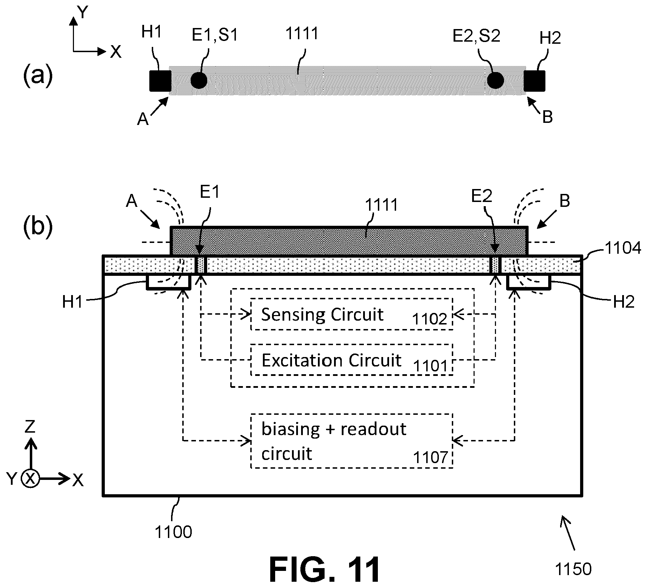

**FIG. 11(a)** shows a top view, and **FIG. 11(b)** shows a side view of an example or a variant of FIG. 8, wherein the sensing contacts S1, 52 coincide with the excitation contacts E1, E2 respectively, and wherein the soft-magnetic component 1111 is a magneto-inductive (MI) element having an elongated shape extending in a direction X parallel to the substrate, and wherein two horizontal Hall elements are located near the longitudinal ends of the MI-element 1111. A processing circuit is not explicitly shown in FIG. 11(a) and FIG. 11(b), but see e.g. FIG. 7 to FIG. 10. The semiconductor device 1150 may have various modes of operation, such as one or more, two or more, or all three of the following:
i) a first mode of operation, wherein the soft-magnetic component 1111 and the excitation circuit 1101 and the sensing circuit 1102 are used as an MI-sensor for measuring a value indicative of an electrical impedance and/or indicative of a magnetic field oriented in the X-direction;
ii) a second mode of operation, wherein the soft-magnetic component 1111 and a test-circuit comprising the excitation circuit 1101 and the sensing circuit 1102, and optionally a comparator (not shown), are used for detecting a mechanical defect of the soft-magnetic component 1111 (e.g. broken or peeled off);
iii) a third mode of operation, wherein the excitation circuit 1101 and the sensing circuit 1102 may be disabled, and wherein the soft-magnetic component 1111 is used an an IMC for guiding magnetic flux lines, and wherein the Hall elements H1, H2 are biased and readout to obtain two signals h1, h2, from which a magnetic field component Bx oriented in the X-direction can be derived, e.g. using the formula: Bx = (h2-h1), and/or from which a magnetic field component Bz oriented in the Z-direction can be derived, e.g. using the formula: Bz=(h1+h2).

In a variant of FIG. 11(a) and FIG. 11(b), (not explicitly shown), the semiconductor substrate 1100 further comprises a modulator and a demodulator, e.g. arranged as illustrated in FIG. 3, FIG. 4, or FIG. 10. Such a semiconductor device may offer:
iv) a fourth mode of operation, in which the magnetic permeability of the soft-magnetic component 1111 is modulated, and wherein the signals obtained from the sensing circuit 1102 are demodulated; and/or
v) a fifth mode of operation, in which the magnetic permeability of the soft-magnetic component 111 is modulated, and the signals obtained from the transducers (e.g. Hall elements) are demodulated.

Embodiments of the present invention may implement one ore more or all of these five modes of operation.

**FIG. 12(a)** shows a top view, and **FIG. 12(b)** shows a side view of a semiconductor device 1250 which is a variant of the semiconductor device 1150 shown in FIG. 11(a) and FIG. 11(b), wherein the soft-magnetic component 1211 is an integrated magnetic field concentrator (IMC) having a disk shape, and wherein two horizontal Hall elements H1, H2 are located near a periphery of the IMC, 180° spaced apart. A processing circuit is not explicitly shown in FIG. 12(a) and FIG. 12(b), but see e.g. FIG. 7 to FIG. 10. The semiconductor device 1250 may have various modes of operation, such as one or more of the following:
i) a first mode of operation, wherein the soft-magnetic component 1211 and a test-circuit comprising the excitation circuit 1201 and the sensing circuit 1202 and optionally a comparator (not shown) can be used for detecting a defect (e.g. mechanical defect) of the IMC 1211, e.g. the IMC being broken or peeled off;
ii) a second mode of operation, wherein the test-circuit may be disabled, and the Hall elements H1, H2 may be biased and readout to obtain two signals h1, h2, from which a magnetic field component Bx oriented in the X-direction can be derived, e.g. using the formula: Bx = (h2-h1), and/or from which a magnetic field component Bz oriented in the Z-direction can be derived, e.g. using the formula: Bz=(h1+h2).

In a variant of FIG. 12(a) and FIG. 12(b), (not explicitly shown), the semiconductor substrate 1200 further comprises a modulator and a demodulator, e.g. arranged as illustrated in FIG. 3, FIG. 4, or FIG. 9. Such a device may have:
iii) a third mode of operation, in which the magnetic permeability of the IMC 1211 is modulated, and the signals h1, h2 obtained from the Hall elements H1, H2 are demodulated.

**FIG. 13** is a simplified representation of a semiconductor device 1250 as illustrated in FIG. 12(a) and FIG. 12(b) or variants thereof, having two electrical contacts c1, c2 and two Horizontal Hall elements H1, H2, angularly spaced by 180°. The Hall elements H1, H2 are located at a first radial distance from the centre of the disk. The electrical contacts c1, c2 are located at a second radial distance from the centre of the disk, smaller than the first radial distance. Preferably, each contact c1, c2 is arranged in close vicinity of a corresponding Hall element. In the example of FIG. 13, the contacts c1, c2 are arranged on a virtual line interconnecting the two Hall elements, but the present invention is not limited thereto, as that is not absolutely required to detect a defect.

**FIG. 14** shows a variant of FIG. 13, where the electrical contacts c1, c2 are also located at a second radius smaller than the first radius, but the angular positions of the electrical contacts are angularly offset by an angle θ from the angular positions of the corresponding horizontal Hall elements.

**FIG. 15** shows another variant of FIG. 13, wherein four horizontal Hall elements H1 to H4 are arranged near the periphery of the disk shaped soft-magnetic component, and are angularly spaced by multiples of 90°, and wherein four electrical contacts c1 to c4 are arranged on a second radius smaller than the first radius, and wherein each electrical contact is arranged in close proximity to a corresponding Hall element.

In a diagnostic test to test the mechanical integrity of the IMC, the contacts may be excited and sensed in a pairwise manner, e.g. by applying at a first moment in time, a voltage between c1 and c2, while leaving c3 and c4 floating (disconnected), and measuring a resulting first current, and comparing the first current with a predefined threshold value,; and by applying at a second moment in time, a voltage between c3 and c4, while leaving c1 and c2 floating (disconnected), and measuring a resulting second current, and comparing the second current with the predefined threshold value, and detecting a defect if one or both of the first and second current is lower than the predefined threshold.

But the present invention is not limited to this particular scheme, and other schemes are possible as well, for example by applying a voltage between c1 and c3 at a first moment in time, and by applying a voltage between c2 and c4 at a second moment in time, and comparing the resulting currents with said predefined threshold value.

In the embodiments shown in FIG. 13 to FIG. 16, the number of contacts is equal to the number of Hall elements, but that is not absolutely required, and in other embodiments, the number of contacts may be higher or lower than the number of Hall elements, as long as there are at least two contacts.

In the embodiments shown in FIG. 13 to FIG. 16, the contacts are all located at the same radial distance, and are angularly spaced uniformly, but that is not absolutely required for the invention to work.

**FIG. 16** shows a variant of FIG. 15, wherein the positions of the four electrical contacts c1 to c2 are angularly offset with respect to the positions of the corresponding Hall elements, in the example by 45°, but another angular offset can also be used. Everything else discussed above is also applicable here.

**FIG. 17A** shows a top view, and **FIG. 17B** shows a side view of an illustrative semiconductor substrate 1700 having two soft-magnetic components IMC1, IMC2, spaced apart from each other over a distance dx, e.g. in the range from about 1.0 mm to about 3.0 mm. In the example shown, each of the soft-magnetic components has two electrical contacts, thus four contacts in total.

In one embodiment, the semiconductor substrate 1700 comprises only a single test circuit comprising a sensing circuit and an excitation circuit and an optional comparator, and a plurality of switches, to test mechanical integrity (or a mechanical defect) for each of the IMC's individually.

In another embodiment, the two IMCs are electrically connected in series, e.g. by providing an electrical interconnection between contact c2 of the first IMC and contact c3 of the second IMC in the semiconductor substrate, and by applying a test voltage over the entire chain (i.e. between c1 and c4), resulting in a current through the entire chain, and this current may then be compared to a predefined threshold. Indeed, if one of the soft-magnetic components is broken or peeled off, the entire chain is broken, and thus the error is detected.

**FIG. 18** is a schematic representation of a semiconductor substrate 1800 comprising a passive soft-magnetic component 1811 in the form of an integrated fluxgate. The semiconductor substrate comprises at least two transducers T1, T2, T3 in the form of at least two coils wrapped around the soft-magnetic component. As mentioned above, the third coil T3 is optional.

Besides the actual function of the transducer, (to sense or measure a magnetic field), in which the soft-magnetic component 1811 is typically left electrically floating, the soft-magnetic component of FIG. 18 furthermore comprises two electrical contacts c1, c2, and the semiconductor substrate 1800 further comprises a test-circuit for detecting a defect of the soft-magnetic component, e.g. similar to the test circuit of FIG. 11 and FIG. 12.

In the example shown in FIG. 18, the two contacts are schematically illustrated as two black circles, representing two "back-contacts" or "bottom contacts", but the present invention is not limited thereto, and "side-contacts", or a combination of "back-contacts" and "side contacts" may also be used.

In another or further variant, the soft-magnetic component comprises four electrical contacts, namely two excitation contacts, and two sensing contacts.

In another or further variant, one or two of the coils are planar spiral coils, preferably implemented in the semiconductor substrate, each situated with their centre near an end of the elongated soft-magnetic shape 1811.

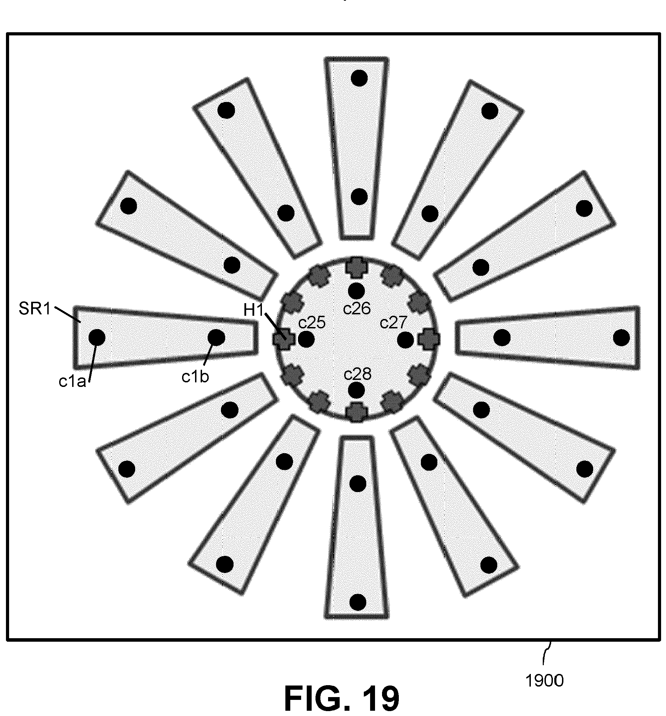

**FIG. 19** shows a semiconductor substrate 1900 with a soft-magnetic structure comprising a central disk and twelve radially oriented segments, angularly spaced by multiples of 360°/12=30°. The semiconductor substrate further comprises twelve horizontal Hall elements H1, etc. arranged at the periphery of the central disk, at angular positions corresponding to angular positions of the radially oriented segments. Each of the twelve segments has two electrical contacts cla, c1b, etc.

The central disk also has at least two electrical contacts, in the example: four electrical contacts c25 to c28. The semiconductor substrate 1900 may comprise circuitry as illustrated in any of FIG. 7 to FIG. 10. The electrical contacts of the individual segments may be "daisy-chained", e.g. in a similar manner as was shown in FIG. 17B. The "normal function" of this structure is "an angle sensor". The electrical contacts and a test-circuit for detecting the mechanical integrity of the structure can be seen as an additional function, e.g. as a diagnostic function.

In a variant (not shown), the semiconductor substrate 1900 has only eight horizontal Hall elements, and eight radially oriented segments, angularly spaced by multiples of 45°.

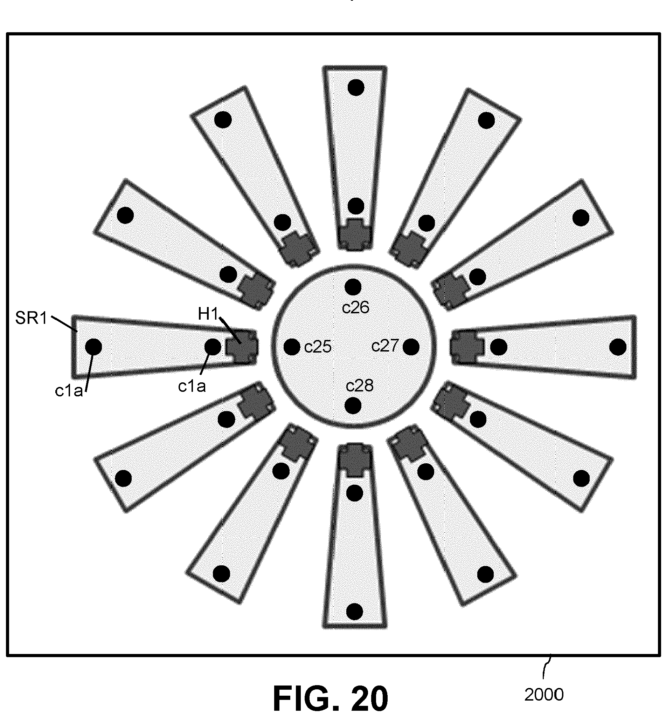

**FIG. 20** shows a semiconductor structure 2000, and can be seen as a variant of FIG. 19 where the Hall elements H1, etc. are situated near an inner end of the radially oriented segments SR1, etc. It is noted that the central disk is not absolutely required, and my be omitted.

**FIG. 21** to **FIG. 23** shows flow-charts of methods that can be used to make a semiconductor substrate (e.g. a CMOS substrate) with a soft-magnetic component (e.g. comprising FeNi or an FeNi alloy), electrically connected to circuitry of the semiconductor substrate by means of "back-contacts" or "side contacts", as described above. FIG. 21 can be seen as a general method. FIG. 22 can be seen as a special case of FIG. 21 wherein the electrical contacts are "back contacts" or "bottom contacts", e.g. as illustrated in FIG. 5. FIG. 23 can be seen as another special case of FIG. 21 wherein the electrical contacts are "side contacts", e.g. as illustrated in FIG. 6.

**FIG. 21** shows a flow chart of a method 2130 of manufacturing a semiconductor substrate, or a semiconductor device (e.g. a sensor device) comprising such a semiconductor substrate. The method 2130 comprises the steps of:
a) providing in step 2131 a semiconductor substrate (e.g. CMOS substrate) comprising electronic circuitry, comprising at least:
   - an excitation circuit;
   - a processing circuit;
   - optionally one or more of: a sensing circuit, at least one electromagnetic transducer (e.g. a Hall element, a coil), an energizing and readout circuit, a modulator, a demodulator;
b) optionally providing in step 2132 a buffer layer (e.g. a polyimide layer) on top of the semiconductor substrate;
c) making in step 2133 at least two openings through an upper layer (e.g. protection layer or buffer layer) of the semiconductor substrate, to form excitation contacts and/or sensing contacts in electrical connection with circuitry of the semiconductor substrate;
d) optionally providing in step 2134 at least one seed layer (e.g. by sputtering) of an electrically conductive material (e.g. Cu);
e) providing in step 2135 a soft-magnetic material (e.g. a thin film of a ferromagnetic material, e.g. FeNi or an Fe-Ni alloy), by sputtering and/or electroplating, e.g. on top of the seed layer, if present.

Step d) may comprise: providing at least one seed layer having a shape with at least one elongated portion.

Step d) may comprise: providing two seed layers, e.g. including a first seed layer to ensure good adhesion (e.g. comprising Ti or a Ti alloy), and a second seed layer (e.g. Cu).

The method may further comprise step f) of annealing the soft magnetic material while applying a static magnetic field oriented in a direction parallel to the semiconductor substrate.

The method may further comprise step g) of flowing a relatively strong electrical current during through the soft-magnetic component during a relatively short time-period, for creating an easy axis.

The method may further comprise one or more of the following steps:
- dicing the semiconductor substrate to form a plurality of semiconductor dies;
- mounting the semiconductor die on a lead frame;
- packaging the semiconductor die by applying a moulding compound.

**FIG. 22** shows a flow chart of a method 2230 of manufacturing a semiconductor substrate, or a semiconductor device (e.g. a sensor device) comprising such a semiconductor substrate. The method of FIG. 22 can be seen as a special case of the method of FIG. 21, wherein the soft-magnetic material is connected with circuitry of the semiconductor substrate via "back contacts" or "bottom contacts". The method 2230 comprises the following steps:
a) providing in step 2231 a semiconductor substrate (e.g. CMOS substrate) comprising electronic circuitry, comprising at least:
   - an excitation circuit;
   - a processing circuit;
   - optionally one or more of: a sensing circuit, at least one electromagnetic transducer (e.g. a Hall element, a coil), an energizing and readout circuit, a modulator, a demodulator;
c) making in step 2233 at least two openings through an upper layer (e.g. protection layer or buffer layer) of the semiconductor substrate, to form excitation contacts and/or sensing contacts in electrical connection with said circuitry;
g) providing in step 2237 "contact pads" in contact with the excitation contacts and/or sensing contacts;
b) providing in step 2232 a buffer layer (e.g. a polyimide layer) on top of the semiconductor substrate, and making at least two (e.g. relatively large) openings through the buffer layer, for contacting the "contact pads";
d) optionally providing in step 2234 at least one seed layer of an electrically conductive material (e.g. Cu);
e) providing in step 2135 a soft-magnetic material (e.g. a thin film of a ferromagnetic material, e.g. FeNi or an Fe-Ni alloy), e.g. by sputtering and/or by electroplating, e.g. on top of the seed layer, if present.

It is an advantage that the steps a), c) and g) can be performed using a standard CMOS process, using CMOS lithography.

The same remarks regarding step d), step f) and optional further steps as made for FIG. 21 are also applicable here.

It is noted that step 2233 and step 2237 are typically used in a CMOS process to form a bonding pad in the top metal of the "metal stack" (also known as "interconnection stack"). The bonding pad would then be routed to circuitry of the semiconductor substrate using the metal layers of the "metal stack".

**FIG. 23** shows a flow chart of a method 2330 of manufacturing a semiconductor substrate, or a semiconductor device (e.g. a sensor device) comprising such a semiconductor substrate. The method of FIG. 23 can be seen as a special case of the method of FIG. 21, wherein the soft-magnetic material is connected with circuitry of the semiconductor substrate via "back contacts" or "bottom contacts". The method 2230 comprises the following steps:
a) providing in step 2331 a semiconductor substrate (e.g. CMOS substrate) comprising electronic circuitry, comprising at least:
   - an excitation circuit;
   - a processing circuit;
   - optionally one or more of: a sensing circuit, at least one electromagnetic transducer (e.g. a Hall element, a coil), an energizing and readout circuit, a modulator, a demodulator;
c) making in step 2333 at least two openings through an upper layer (e.g. protection layer or buffer layer) of the semiconductor substrate, to form excitation contacts and/or sensing contacts in electrical connection with circuitry of the semiconductor substrate;
g) providing in step 2337 "contact pads" in contact with the excitation contacts and/or sensing contacts;
b) providing in step 2332 a buffer layer (e.g. a polyimide layer) on top of the semiconductor substrate, and making at least two (e.g. relatively large) openings through the buffer layer, for contacting the "contact pads";
d) optionally providing in step 2334 at least one seed layer of an electrically conductive material (e.g. Cu);
h) providing in step 2338 a mask at the envisioned location of the soft-magnetic component;
i) depositing in step 2339 an electrically conductive material (e.g. Cu) in the openings, e.g. by sputtering;
j) providing in step 2340 a mask over the electrically conductive material (e.g. Cu) present in said openings;
e) providing in step 2335 a soft-magnetic material (e.g. a thin film of a ferromagnetic material, e.g. FeNi or an Fe-Ni alloy), e.g. by sputtering and/or by electroplating, e.g. on top of the seed layer, if present.

The same remarks regarding step d), step f) and optional further steps as made for FIG. 21 are also applicable here.

### REFERENCES:

- E1, E2: excitation contact
- 51, S2: sensing contact
- H1, H2: horizontal Hall element
- c1, c2: electrical contacts

### REFERENCES (module 100):

- 00: semiconductor substrate
- 01: excitation circuit
- 02: sensing circuit
- 04: buffer layer
- 06: processing circuit
- 07: "biasing and readout" circuit for Hall elements
- 08: seed layer
- 10: sensor structure or sensor arrangement
- 11: soft-magnetic element
- 15: cavity
- 16: opening
- 17: modulator
- 30: method
- 50: semiconductor device (e.g. sensor device)
- 51: contact pads
- 52: passivation layer or intermediate layer
- 53: passivation layer
- 54: buffer layer, e.g. polyimide layer
- 55: seed layer
- 56: contact surface (on a lateral side of the soft-magnetic element)

## Claims

1. A semiconductor device, comprising:
- a semiconductor substrate (100) comprising: an excitation circuit (101) for applying an excitation signal, and a soft-magnetic component (111) for guiding magnetic flux lines;
wherein the soft-magnetic component (111) is electrically connected to said excitation circuit by means of at least two electrical contacts (E1, 51);
wherein the at least two electrical contacts are back contacts situated at a bottom surface of the soft-magnetic component (111) side contacts situated at a lateral surface of the soft magnetic component (111);
wherein the semiconductor substrate further comprises at least one electromagnetic transducer (H1, H2) arranged in close vicinity of the soft-magnetic component, and operatively connected thereto;
wherein the excitation circuit comprises a modulator for providing a modulated signal to the soft-magnetic component in order to modulate its magnetic permeability;
wherein the semiconductor device further comprises a demodulator configured to demodulate signals obtained from the at least one electromagnetic transducer (H1, H2).

2. A semiconductor device, comprising:
- a semiconductor substrate (100) comprising: an excitation circuit (101) for generating an excitation signal, and a sensing circuit for measuring or detecting a response signal, and a soft-magnetic component (111) for guiding magnetic flux lines;
wherein the soft-magnetic component (111) is electrically connected to said excitation circuit and to said sensing circuit by means of at least two electrical contacts (E1, 51);
wherein the at least two electrical contacts are back contacts situated at a bottom surface of the soft-magnetic component (111) or side contacts situated at a lateral surface of the soft magnetic component (111);
wherein the semiconductor device is configured to detect a defect based on the response signal.

3. A semiconductor device according to claim 2,
wherein the semiconductor substrate further comprises at least one electromagnetic transducer (H1, H2) arranged in close vicinity of the soft-magnetic component;
and wherein the semiconductor substrate further comprises an energizing and readout circuit connected to said at least one electromagnetic transducer;
and wherein the semiconductor device has a first mode of operation, wherein the excitation circuit and sensing circuit are actively used to detect a defect;
and wherein the semiconductor device has a second mode of operation, wherein the excitation circuit is deactivated, and the energizing and readout circuit are used to obtain a signal from the electromagnetic transducers.

4. A semiconductor device according to claim 1 or claim 3,
wherein the at least one electromagnetic transducer is at least one Hall element;
or wherein the at least one electromagnetic transducer is at least one coil.

5. A semiconductor device according to claim 2,
wherein the excitation circuit (101) is electrically connected to the soft-magnetic component (111) at a first and a second excitation contact (E1, E2); and
wherein the sensing circuit (102) is electrically connected to the soft-magnetic component (111) at a first and a second sensing contact (51, S2).

6. A semiconductor device according to claim 5,
wherein the first excitation contact (E1) coincides with the first sensing contact (51) and the second excitation contact (E2) coincides with the second sensing contact (S2);
or wherein the first and the second sensing contact (51, S2) are situated between the first and the second excitation contact (E1, E2).

7. A semiconductor device according to any of the previous claims,
wherein the semiconductor substrate further comprises a buffer layer;
and wherein the soft-magnetic component is arranged on top of this buffer layer.

8. A semiconductor device according to claim 7,
wherein the excitation circuit and the sensing circuit are electrically connected to the soft-magnetic component by means of electrical interconnections passing through the buffer layer.

9. A semiconductor device according to any of the previous claims,
further comprising biasing means for generating a DC magnetic field in the soft-magnetic component.

10. A semiconductor device according to any of the previous claims,
wherein the soft-magnetic component has a cross-section with rounded or truncated edges or corners.

11. A semiconductor device according to any of the previous claims,
wherein the semiconductor substrate further comprises two soft-magnetic trapezoidal shapes (512a, 512b) arranged near opposite ends (A, B) of the soft-magnetic element (510).

12. A semiconductor device according to any of the previous claims,
wherein the soft-magnetic component has a circular shape;
and wherein the semiconductor substrate comprises a plurality of at least two Horizontal Hall elements arranged near a periphery of the soft-magnetic component;
and wherein the soft-magnetic component is electrically connected to the semiconductor substrate by means of a plurality of at least two electrical contacts (c1, c2).

13. A semiconductor device according to any of the previous claims,
further comprising a second soft-magnetic component (IMC2);
wherein the first soft magnetic component (IMC1) comprises at least a first and second electrical contact (c1, c2); and
wherein the second soft magnetic component (IMC2) comprises at least a third and fourth electrical contact (c3, c4); and
wherein the second electrical contact (c2) is electrically connected to the third electrical contact (c3) in the semiconductor substrate; and
wherein the excitation signal is applied to the first electrical contact (c1), and the sensed signal is obtained from the fourth electrical contact (c4).

14. A method (2130) of producing a semiconductor substrate comprising the steps of:
a) providing (2131) a semiconductor substrate comprising electronic circuitry, comprising at least an excitation circuit, and a processing circuit;
b) optionally providing (2132) a buffer layer on top of the semiconductor substrate;
c) making (2133) at least two openings through an upper layer of the semiconductor substrate, to form excitation contacts and/or sensing contacts in electrical connection with said circuitry;
d) optionally providing (2134) at least one seed layer of an electrically conductive material;
e) providing (2135) a soft-magnetic material, e.g. by sputtering and/or by electroplating.

15. Method (2230; 2330) according to claim 14, further comprising one of more of the following features:
- wherein the semiconductor substrate provided in step a) is a CMOS substrate;
- wherein the semiconductor substrate provided in step a) further comprises at least two horizontal Hall elements, and a biasing and readout circuit;
- wherein the method further comprises: providing at least one seed layer of an electrically conductive material;
- wherein the semiconductor substrate provided in step a) further comprises a buffer layer on top of the semiconductor substrate;
- further comprising a step of wet etching or anisotropic etching after applying the soft-magnetic material, in order to provide rounded or truncated ends and/or edges;
- wherein the method further comprises step f) of annealing (2136) the soft-magnetic material while applying a static magnetic field oriented in a direction parallel to the semiconductor substrate;
- wherein the method further comprises a step of creating an easy magnetization axis by flowing a relatively large current through the soft-magnetic component during a predefined time.
